# FASCICULE DE BREVET EUROPEEN

(11) **EP 2 561 560 B1**
(45) Date de publication et mention de la délivrance du brevet: **30.04.2014**
(21) Numéro de dépôt: 11721806.5
(22) Date de dépôt: 20.04.2011
(51) Int. Cl.: H01L 51/42, B82Y 10/00, H01L 51/44, H01L 51/46

(54) **CELLULE SOLAIRE ORGANIQUE À HÉTÉROJONCTION EN VOLUME COMPRENANT UNE COUCHE ACTIVE ÉLECTRIQUEMENT, PRÉSENTANT UNE SÉGRÉGATION VERTICALE.**
BULK-HETEROÜBERGANGS-SOLARZELLEN ENTHALTEND EINE ELEKTRISCHE AKTIVE SCHICHT MIT EINER VERTIKALTRENNUNG
BULK HETEROJUNCTION ORGANIC PHOTOVOLTAIC CELL COMPRISING AN ELECTRICALLY ACTIVE LAYER HAVING A VERTICAL SEGREGATION

(30) Priorité: 22.04.2010 FR 1001727
(43) Date de publication de la demande: 27.02.2013
(73) Titulaire: Commissariat à l'Énergie Atomique et aux Énergies Alternatives, 75015 Paris (FR)
(72) Inventeur: BERSON, Solenn, F-73000 Chambéry (FR); BAILLY, Séverine, F-73290 La Motte-Servolex (FR); GUILLEREZ, Stéphane, F-73610 Lepin Le lac (FR); LEMAITRE, Noella, F-73000 Chambéry (FR)
(74) Mandataire: Talbot, Alexandre
(86) Numéro de dépôt international: PCT/FR2011/000239
(87) Numéro de publication internationale: WO 2011/131864

(56) Documents cités:
- WO-A1-2010/038721
- US-A1- 2008 142 079
- US-A1- 2010 012 178
- JEON S O ET AL: "Improved efficiency in organic solar cells through fluorinated interlayer induced crystallization", ORGANIC ELECTRONICS, ELSEVIER, AMSTERDAM, NL, vol. 10, no. 8, 1 décembre 2009 (2009-12-01), pages 1583-1589, XP026746944, ISSN: 1566-1199, DOI: DOI:10.1016/J.ORGEL.2009.09.005 [extrait le 2009-09-13]
- Zheng Xu ET AL: "Vertical phase separation in poly(3-hexylthiophene): fullerene derivative blends and its advantage for inverted structure solar cells", , 23 avril 2009 (2009-04-23), pages 1227-1234, XP55001200, DOI: 10.1002/adfm.200801286 [extrait le 2011-06-22]

## Description

### Domaine technique de l'invention

L'invention concerne une cellule solaire organique à hétérojonction en volume.

### État de la technique

Le développement des dispositifs électroniques organiques, tels que les transistors organiques (OFET), les diodes électroluminescentes organiques (OLED), les cellules solaires organiques (OPV ou cellules photovoltaïques organiques), est à un stade industriel ou préindustriel.

Cependant, les matériaux actifs ainsi que les architectures des dispositifs sont encore en cours d'évolution, afin de répondre aux critères de performances et de durée de vie permettant d'élargir les champs d'application de ces technologies. En particulier, il est souhaitable de chercher des voies d'amélioration des rendements et de la stabilité des dispositifs actuels.

Dans certains cas, le coeur des dispositifs électroniques organiques est constitué d'une couche active électriquement, également appelée couche active et formée par voie humide à l'aide d'un mélange contenant au moins deux matériaux semi-conducteurs, respectivement de type n (accepteur d'électrons) et de type p (donneur d'électrons). C'est notamment le cas des cellules solaires organiques à hétérojonction en volume (également connues sous le nom anglo-saxon de « bulk heterojunction OPV Devices »), des diodes électroluminescentes et des transistors organiques ambipolaires. Or, l'organisation des matériaux semi-conducteurs de type n et de type p au sein de la couche active, correspondant à la morphologie de la couche active, est un facteur primordial au bon fonctionnement des dispositifs électroniques.

En particulier, dans le cas des cellules solaires organiques à hétérojonction en volume, la morphologie du mélange constituant la couche active électriquement est primordiale pour obtenir de bons transferts et transports de charges et conduire ainsi à de hauts rendements de conversion.

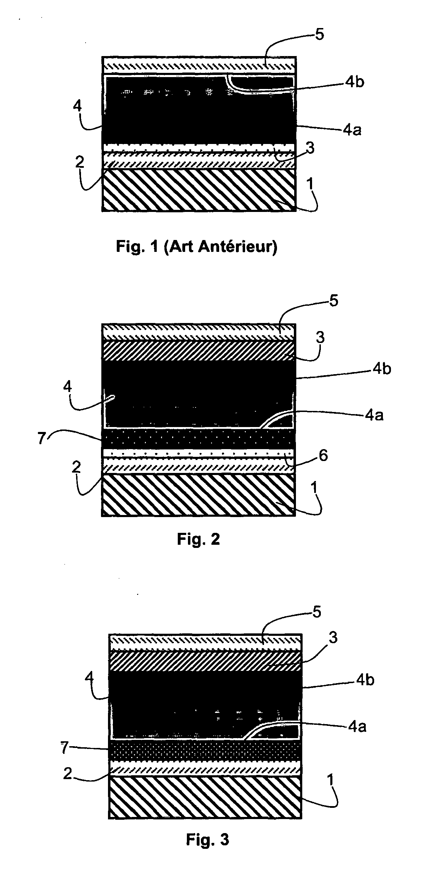

À titre d'exemple, une cellule solaire organique à hétérojonction en volume de structure standard, selon l'art antérieur est illustrée sur la figure 1. Celle-ci est formée d'un empilement multicouche comprenant successivement :
- un substrat 1, par exemple en verre ou en matière plastique,
- une première électrode 2, par exemple une couche mince en oxyde d'indium et d'étain (ITO)
- une couche d'injection de trous 3, par exemple constituée par un poly(3,4-éthylènedioxythiophène) :poly(styrène-sulfonate) connu sous le nom PEDOT :PSS,
- une couche active électriquement 4, obtenue par un mélange de matériaux organiques semi-conducteurs de type p et de type n, par exemple un mélange de P3HT (poly(3-hexylthiophène) et de PCBM ([6,6]-phényl-C61-butyrate de méthyle) et comprenant des faces opposées 4a et 4b
- et une seconde électrode 5 en matériau conducteur électriquement, telle qu'un bicouche mince calcium/aluminium.

Dans ce mode de réalisation, les première et seconde électrodes 2 et 5 forment respectivement une anode et une cathode.

Différents facteurs ont été rapportés dans la littérature comme des paramètres influençant la morphologie de la couche active 4. Ces paramètres sont, le plus souvent, liés au procédé d'élaboration de la cellule solaire organique, et en particulier à la nature et aux propriétés de la solution initiale utilisée pour former la couche active 4, ainsi qu'aux paramètres cinétiques intervenant lors de la formation de la couche active 4 et aux techniques de dépôt.

Tous ces paramètres doivent être contrôlés afin d'obtenir une morphologie optimale et plus particulièrement une surface de contact la plus grande possible avec la cathode pour le matériau semi-conducteur de type n et une surface de contact la plus grande possible avec l'anode pour le matériau semi-conducteur de type p, ceci dans le but d'avoir une bonne extraction des charges à chacune des électrodes.

Ainsi, comme rapporté dans l'article « Three-Dimensional Nanoscale Organization of Bulk Heterojunction Polymer Solar Cells » de Svetlana S. van Bavel et al. (Nano Letters 2009 Vol.9, No. 2, 507-513), une couche active d'une cellule photovoltaïque organique à hétérojonction en volume de structure standard comprend idéalement un réseau constitué du matériau semi-conducteur de type n et un réseau constitué du matériau semi-conducteur de type p, avec des gradients de concentration respectifs pour chacun des matériaux semi-conducteurs de type p ou de type n opposés à travers l'épaisseur de la couche active. Une telle morphologie de mélange correspond à une ségrégation verticale des matériaux semi-conducteurs des types p et n.

Dans l'article précité, Svetlana S. van Bavel et al. ont observé une telle ségrégation verticale en modifiant certaines conditions lors du procédé de fabrication, et notamment en réalisant un recuit thermique ou un recuit assisté par solvant, de cellules solaires organiques à hétérojonction en volume de structure standard. Les cellules ont été réalisées à partir d'un mélange contenant du P3HT et du PCBM dissous dans de l'ODCB (ortho-dichlorobenzène), avec un rapport en poids de 1 :1 et une concentration totale de 20mg/ml. Le mélange a été déposé à la tournette (technique également connue sous le terme anglo-saxon de « spin-coating »), à une vitesse de 500 tours/min sur un substrat 1 en verre recouvert d'une couche 2 en ITO et d'une couche 3 en PEDOT :PSS de 70 nm d'épaisseur. Une amélioration de la morphologie de la couche active 4 est observée par tomographie électronique pour des cellules ayant subies un recuit thermique à 130°C pendant 20 minutes ou un recuit assisté par solvant pendant 3 heures.

À titre d'illustration, la couche active 4 représentée sur la figure 1 et correspondant au mode de réalisation décrit dans l'article de Svetlana S. van Bavel et al. présente une ségrégation verticale entre le matériau semi-conducteur de type p et le matériau semi-conducteur de type n. Une telle ségrégation verticale est plus particulièrement représentée, sur la figure 1, par un dégradé allant progressivement du noir au gris clair, depuis la face 4b de la couche active 4 jusqu'à la face opposée 4a. Un tel dégradé illustre, ainsi une concentration en matériau semi-conducteur de type p (par exemple P3HT) et une concentration en matériau semi-conducteur de type n (PCBM), respectivement décroissante et croissante depuis la face 4a jusqu'à la face 4b de la couche active 4.

Par ailleurs, dans l'article « Morphology Control in Solution-Processed Bulk-Heterojunction Solar Cell Mixtures » (Adv. Funct. Mater, 2009, 19, 3028-3026), Adam J. Moulé et al. passent en revue les techniques développées ces dernières années pour contrôler la morphologie des mélanges polymère/fullerène formant une couche active dans une cellule à hétérojonction en volume de structure standard et donc pour obtenir des rendements améliorés. En particulier, ils citent des techniques mettant en oeuvre des suspensions de nanoparticules de polymère. À titre d'exemple, une telle technique est rapportée dans l'article « Poly(3-hexylthiophène) fibers for Photovoltaic Applications » de Solenn Berson et al. (Adv. Funct. Mater. 2007, 17, 1377-1384). Adam J. Moulé et al. mentionnent également l'emploi de mélanges de solvants ou d'additifs à ajouter au solvant. À titre d'exemple, dans l'article « Processing Additives for Improved Efficiency from Bulk Heterojunction Solar Cells » de (J. Am. Chem. SOC. 2008, 130, 3619-3623), Jae Kwan Lee et al. ont étudié les critères permettant de choisir un additif parmi la classe des 1,8-di(R)octanes, à ajouter à la solution initiale afin de contrôler la morphologie d'une couche active en PCPDTBT ([2,6-(4,4-bis(2-éthylhexyl)-4H-cyclopenta[2,1-b ;3,4-b']-dithiophène)-alt-4,7-(2,1,3-benzothiadiazole)]) et en C₇₁-PCBM.

Il existe, par ailleurs, des cellules à hétérojonction en volume présentant une structure différente de la structure standard telle que représentée sur la figure 1. De telles cellules sont dites cellules à hétérojonction en volume à structure inversée. Elles ont, par exemple, été rapportées dans la seconde partie de l'article « Recent Progress in Polymer Solar Cells : Manipulation of Polymer : Fullerene Morphology and the Formation of Efficient Inverted Polymer Solar Cells » de Li-Min Chen et al. (Adv. Mater. 2009, 21, 1-16). Par rapport aux cellules à hétérojonction en volume de structure standard, elles sont caractérisées par :
- une substitution de la cathode (référence 5 sur la figure 1) de la structure standard par une couche en PEDOT :PSS ou en oxyde de métal de transition ayant une fonction de travail élevée (par exemple V₂O₅ ou MoO₃) et recouverte par une électrode réalisée avec un métal stable tel que l'or ou l'argent
- et par une substitution de la couche en PEDOT :PSS (référence 3 sur la figure 1) disposée dans la structure standard entre la couche en ITO (référence 2 sur la figure 1) et la couche active (référence 4 sur la figure 1) par une autre couche tampon fonctionnelle, par exemple constituée par un composé ayant une fonction de travail faible. Une telle couche tampon permet la collecte des électrons, de sorte qu'elle joue le rôle de cathode dans la structure inversée.

Ainsi, la polarité d'une cellule à hétérojonction en volume étant contrôlée par les positions relatives des couches fonctionnelles ayant des fonctions de travail différentes, la polarité des cellules ayant dans une structure inversée est inversée par rapport à celle des cellules à structure standard, indépendamment des électrodes conductrices.

À l'heure actuelle, les cellules à hétérojonction en volume de structure inversée présentent des performances inférieures à celles des cellules à hétérojonction en volume de structure standard, car les procédés de fabrication ne sont pas encore optimisés. En effet, la réalisation de l'empilement des différentes couches minces diffère selon la structure standard ou inversée de la cellule à hétérojonction en volume. De plus, les cellules à hétérojonction en volume de structure inversée étant moins performantes, il n'y a, à notre connaissance, pas d'étude menée pour favoriser la ségrégation verticale dans la couche active des cellules à hétérojonction en volume de structure inversée.

Le document US2008/142079 décrit une cellule photovoltaïque comprenant une première électrode, une seconde électrode, une couche photoactive disposée entre les première et seconde électrodes, et une couche organique polaire disposée entre la couche photoactive et au moins une des première et seconde électrodes. La présence de la couche organique polaire permettrait, selon le document US2008/142079, d'augmenter de manière significative la densité de photocourant de la cellule.

Le document US 2010 /00 12 178 décrit une cellule solaire organique comprenant une première électrode, une seconde électrode, une couche photoactive entre les première et seconde électrodes et une couche d'interface entre la couche active et la deuxième électrode. La couche d'interface comprend un mélange d'au moins un oxide métallique et d'au moins un sel. Le document, "Vertical Phase Separation in Poly(3-hexylthiophene): fulluene Derivative Blends and its Advantage for invented solar cells", Zheng Xu et al., Adv. Functional Materials, 2009, 19, 1227-1234 décrit une cellule solaire organique comportant une couche de Cs₂CO₃.

Le document, "Improved efficiency in organic solar cells through fluorinated interlayer induced crystallization," Soon Ok Jeon et al., Organic Electronics 10 (2009), 1583-1589, décrit l'utilisation d'une couche de PVDF comme intercouche entre la couche active et l'anode d'une cellule solaire organique.

### Objet de l'invention

L'invention a pour but de proposer une cellule solaire organique à hétérojonction en volume, dont les performances sont améliorées par rapport aux cellules solaires organiques à hétérojonction en volume selon l'art antérieur.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente une cellule solaire organique à hétérojonction en volume à structure standard selon l'art antérieur.
- la figure 2 représente un mode particulier de réalisation d'une cellule solaire organique à hétérojonction en volume à structure inversée selon l'invention.
- la figure 3 illustre une variante de réalisation d'une cellule selon la figure 2.
- la figure 4 représente l'évolution du rendement de conversion η (en %) en fonction du temps pour quatre cellules solaires organiques : deux cellules selon l'invention comprenant chacune une couche additionnelle contenant du P4VP et du PCMB (Cellules A1 et B1) et deux cellules selon l'art antérieur (Cellules C1 et D1).
- la figure 5 représente l'évolution du rendement de conversion η (en %) en fonction du temps pour six cellules solaires organiques : cinq cellules selon l'invention comprenant chacune une couche additionnelle contenant du P4VP et ZnO (Cellules A1 à E1) et une cellule selon l'art antérieur (cellule F1).

### Description de modes particuliers de réalisation

La couche active électriquement d'une cellule solaire organique à hétérojonction en volume est associée à une couche additionnelle, afin de favoriser la ségrégation verticale entre le matériau semi-conducteur organique de type p et le matériau semi-conducteur carboné de type n, présents dans la couche active électriquement.

Le matériau carboné semi-conducteur de type n contenu dans la couche active est, choisi parmi :
- les fullerènes, par exemple le fullerène C60, le fullerène C70, le fullerène C80 ou le fullerène C84,
- des nanotubes de carbone semi-conducteurs,
- le graphène et les nanographènes,
- et leurs dérivés solubles, tels que le [6,6]-phényl-C61-butyrate de méthyle également connu sous le nom PCBM ou PC₆₁BM, le [6,6]-phényl-C71-butyrate de méthyle ou PC₇₁BM, un thiophène-C61-butyrate de méthyle, un multi-adduit d'un fullerène C60 ou C70 ou des nanotubes de carbone fonctionnalisés.

Le matériau organique semi-conducteur de type p contenu dans la couche active est choisi parmi les polymères ou copolymères à base de thiophène, de carbazole, de benzothiadiazole, de cyclopentadithiophène, de dikétopyrrolopyrrole. Il est, par exemple, constitué par du (poly(3-hexylthiophène) également connu sous le nom de P3HT.

Plus particulièrement, la couche additionnelle comprend un composé spécifiquement choisi pour son aptitude à former des interactions non covalentes avec le matériau carboné semi-conducteur de type n présent dans la couche active électriquement. La couche additionnelle peut, aussi, être appelée « couche carbophile », dans la mesure où elle présente une certaine affinité avec le carbone du matériau semi-conducteur carboné de type n présent dans la couche active électriquement. La couche additionnelle est, de plus, en contact direct avec la couche active électriquement. Par conséquent, aucune couche intermédiaire n'est disposée entre la couche active électriquement et la couche additionnelle.

Pour les matériaux carbonés semi-conducteurs de type n mentionnés ci-dessus, le composé formant des interactions non covalentes avec le matériau carboné semi-conducteur de type n et présent dans la couche additionnelle est un polymère choisi parmi :
- des polymères fluorés, par exemple choisis parmi le polyfluorure de vinylidène, un polytétrafluoroéthylène, un copolymère de tétrafluoréthylène et de perfluorovinyléther.
- et des polymères ayant des chaînes latérales comportant au moins un groupement aromatique azoté, avantageusement, choisi parmi la pyridine, la pyrimidine, la pyrazine, la pyridazine et la triazine. Le composé peut, par exemple, être un polymère choisi parmi les polyvinylpyrimidines, les polyvinylpyrazines, les polyvinylpyridazines, la poly(2-vinyl-pyridine) et la poly(4-vinyl-pyridine) également nommée P4VP.

Par ailleurs, la couche additionnelle disposée dans une cellule solaire organique à hétérojonction en volume comporte, un matériau semi-conducteur de type n, en plus du composé formant des interactions non covalentes avec le matériau carboné semi-conducteur de type n contenu dans la couche active électrique. En particulier, le matériau semi-conducteur de type n contenu dans la couche additionnelle peut être un élément semi-conducteur de type n jouant le rôle de dopant, tel que le PCBM. Il peut aussi s'agir d'un matériau semi-conducteur inorganique de type n, tel que ZnO ou TiOₓ. Dans ce dernier cas, la couche additionnelle peut jouer le rôle de couche d'injection d'électrons, disposée directement entre la cathode et la couche active électriquement.

Ainsi, le fait d'associer une telle couche additionnelle à la couche active électriquement d'une cellule solaire organique à hétérojonction en volume permet de favoriser la ségrégation verticale entre le matériau semi-conducteur organique de type p et le matériau semi-conducteur carboné de type n, présents dans la couche active électriquement.

Une telle association correspond, avantageusement, à une mise en contact directe de la couche active électriquement avec ladite couche additionnelle, lors du procédé de fabrication de la cellule solaire organique à hétérojonction en volume. Ainsi, la ségrégation verticale est, plus particulièrement, favorisée et obtenue lors de la formation de la couche active par voie humide, à partir d'un mélange homogène contenant les matériaux semi-conducteurs de type p et de type n, directement sur la couche additionnelle préalablement formée.

La couche active électriquement peut, en particulier, être formée sur la couche additionnelle, par différentes méthodes de dépôt d'un mélange liquide comprenant les matériaux semi-conducteurs respectivement de type p et de type n, telles que le dépôt à la tournette (« spin-coating »), l'enduction ou une méthode d'impression, telle que les techniques par jet d'encre, sérigraphie, héliographie...Elle peut, ensuite, subir une étape de traitement thermique afin d'améliorer encore la ségrégation verticale. Le traitement thermique est, par exemple, réalisé entre 50°C et 180°C, pendant une durée comprise entre 1 minute et 30 minutes.

Par ailleurs, la couche additionnelle, formée avant la couche active, peut aussi être réalisée par différentes méthodes de dépôt d'une solution contenant le composé destiné à former des interactions non covalentes avec le matériau carboné semi-conducteur de type n.

En particulier, un tel composé est mis en solution avec le matériau semi-conducteur de type n entrant dans la composition de la couche additionnelle. Lorsque le matériau semi-conducteur de type n est un élément dopant pour la couche additionnelle, celle-ci a, avantageusement, une épaisseur inférieure à 5nm. Sinon, la couche additionnelle a, avantageusement, une épaisseur comprise entre 5nm et 50nm. De plus, selon sa nature, le composé peut aussi être sous forme liquide ou bien sous forme de poudre. Par ailleurs, les techniques de dépôt utilisées pour déposer la solution destinée à former la couche additionnelle sur un support peuvent être les mêmes que celles utilisées pour former la couche active électriquement (dépôt à la tournette, enduction impression par jet d'encre, par sérigraphie ou par héliographie...). Enfin, une fois la couche additionnelle formée et avant le dépôt de la couche active électriquement, la couche additionnelle peut, dans certains cas, subir un recuit thermique entre 25°C et 450°C.

Le support sur lequel est déposée la couche additionnelle dépend du type de cellule solaire organique à hétérojonction en volume que l'on souhaite réaliser. En particulier, la couche additionnelle peut être déposée directement sur une des deux électrodes (en particulier la cathode) de la cellule solaire organique ou bien sur une couche mince intermédiaire, elle même en contact avec ladite électrode. La couche intermédiaire est plus particulièrement formée par un matériau semi-conducteur de type n.

À titre d'exemple, le support sur lequel est formée la couche additionnelle peut, par exemple, être un empilement multicouche formé par un substrat en verre ou en plastique, une couche mince en matériau conducteur électriquement formant une électrode (et formant plus particulièrement la cathode) et éventuellement une couche mince intermédiaire.

Ainsi, lors de la formation de la couche active sur la couche additionnelle, le matériau semi-conducteur carboné de type n présent dans la solution destinée à former la couche active est attiré de manière spontanée vers l'interface entre ladite solution et la couche additionnelle, tandis que le matériau semi-conducteur de type p a tendance à se déplacer à l'opposé. Ainsi, les répartitions respectives du matériau carboné semi-conducteur de type n et du matériau organique semi-conducteur de type p dans la couche active électriquement vont être spontanément et naturellement perturbées, lors de la formation de la couche active électriquement sur la couche additionnelle préalablement formée. En particulier, la présence de la couche additionnelle va permettre d'obtenir :
- une concentration pour le matériau carboné semi-conducteur de type n, variant de manière décroissante dans la couche active électriquement, depuis la face de la couche active en contact avec la couche additionnelle jusqu'à la face opposée de ladite couche active
- et une concentration, pour le matériau organique semi-conducteur de type p, variant de manière croissante dans la couche active électriquement, depuis la face de la couche active en contact avec la couche additionnelle jusqu'à la face opposée de ladite couche active.

Plus particulièrement, au niveau de la face de la couche active électriquement qui est en contact direct avec la couche additionnelle, la proportion en matériau carboné semi-conducteur de type n est supérieure à 50% en poids par rapport au poids total de la couche active électriquement. À l'inverse, c'est la proportion en matériau organique semi-conducteur de type p qui est supérieure à 50% en poids par rapport au poids total de la couche active électriquement au niveau de la face opposée de la couche active.

Une telle disposition est particulièrement avantageuse pour les cellules solaires organiques à hétérojonction en volume. En effet, l'obtention d'une telle ségrégation verticale dans la couche active d'une cellule solaire organique à hétérojonction en volume assure notamment l'amélioration des performances des cellules et plus particulièrement l'obtention d'un bon rendement de conversion. Le rendement de conversion est, plus particulièrement noté η et répond à la formule suivante : η = (Voc*Jsc*FF)/P dans laquelle Voc correspond à la tension en circuit ouvert, Jsc correspond à la densité de courant en cour-circuit, FF est le facteur de forme de la cellule et P est la puissance incidente. Il est, en général, mesuré sous une illumination AM 1.5 avec une puissance incidente de 100mW.cm⁻² et il est exprimé en pourcentage.

En particulier, l'insertion de la couche additionnelle permet de favoriser une morphologie selon laquelle les matériaux semi-conducteurs, respectivement de type n et de type p, ont des grandes surfaces de contact, avec les couches respectivement disposées du côté de la cathode et de l'anode.

À titre d'exemple, un premier mode particulier de réalisation d'une cellule solaire organique à hétérojonction en volume de structure inversée est représenté sur la figure 2.

Une cellule est, en particulier, constituée d'un empilement multicouche formé par:
- un substrat 1, par exemple en verre,
- une couche mince 2 en matériau conducteur électriquement, tel que l'oxyde d'indium et d'étain (ITO) et formant une première électrode,
- une couche mince intermédiaire 6 en matériau semi-conducteur de type n par exemple en oxyde de zinc (ZnOₓ) ou en oxyde de titane (TiOₓ) et formant une couche d'injection d'électrons,
- une couche additionnelle 7, constituée par exemple de P4VP (ou poly(4-vinyl-pyridine)) dopée par du PCBM (noté ci-après P4VP+PCBM),
- une couche active électriquement 4, par exemple constituée d'un mélange de P3HT et de PCBM (noté ci-après P3HT :PCBM),
- une couche mince 3 en matériau semi-conducteur de type p, tel qu'un poly(3,4-éthylènedioxythiophène) :poly(styrène-sulfonate) connu sous le nom PEDOT :PSS ou NiOₓ ou CuOₓ et formant une couche d'injection de trous,
- et une couche mince 5 en matériau conducteur électriquement, tel que l'argent et formant une seconde électrode en matériau conducteur électriquement.

Dans ce mode particulier de réalisation, les première et seconde électrodes 2 et 5 forment, respectivement, la cathode et l'anode de la cellule.

Une cellule solaire organique à hétérojonction en volume de structure inversée particulière, selon la figure 2, peut, par exemple, être obtenue selon un procédé de réalisation comprenant les étapes successives suivantes :
- Etape 1 : la couche mince intermédiaire 6, par exemple en ZnO, est formée par dépôt à la tournette, à partir d'une solution précurseur, sur une couche mince 2 en ITO recouvrant un substrat en verre 1. Le dépôt est réalisé pendant 60s à une vitesse de 1000 tr.min⁻¹, puis pendant 30s à une vitesse de 2000 tr.min⁻¹. De plus, le dépôt est réalisé à l'air et l'épaisseur de la couche mince intermédiaire 6 obtenue est d'environ 15 nm. Le dépôt est suivi d'une phase de séchage par recuit réalisée à l'aide d'une plaque chauffante, à une température de 150°C, pendant 1 h.
- Etape 2 : une solution contenant un mélange de P4VP+PCBM (1g/L de P4VP dans de l'isopropanol avec un taux de 10% en poids de PCBM par rapport au poids de la P4VP) est déposée à la tournette sur la couche mince intermédiaire 6, une fois celle-ci séchée, à une vitesse de 5000 tr.min⁻¹ pendant 25s, puis à une vitesse de 4000 tr.min⁻¹ pendant 25s. Le dépôt est suivi d'une phase de séchage par recuit réalisée à l'aide d'une plaque chauffante, à une température de 150°C, pendant 15 minutes. La couche additionnelle 7 a une épaisseur inférieure à 5nm.
- Etape 3 : le dépôt de la couche active électriquement 4 est réalisé sur la couche additionnelle 7, par dépôt à la tournette d'une composition de P3HT :PCBM, à une vitesse d'environ 1500 tr.min⁻¹ pendant 40s, puis à une vitesse de 2000 tr.min⁻¹ pendant 35s. L'épaisseur de la couche active 4 obtenue est comprise entre 200 et 250nm et le rapport en poids entre P3HT et PCBM est de 1 :1.
- Etape 4 : la couche d'injection de trous 3 est déposée à la tournette sur la couche active 4, à une vitesse de 2000tr.min⁻¹ pendant 25s, puis à une vitesse de 3000 tr.min⁻¹ pendant 25s. La couche d'injection de trous 3 a une épaisseur d'environ 50nm. L'empilement ainsi obtenu est alors disposé dans une boîte à gants, pour y subir un recuit pendant 15 minutes à 150°C.
- Etapé 5 : une couche mince 5, par exemple en argent et d'une épaisseur de 100 nm, est ensuite déposée par évaporation sous vide.

Dans ce mode de réalisation, la couche additionnelle 7 est formée sur une couche mince intermédiaire 6 en matériau semi-conducteur de type n disposée sur la couche mince 2 en matériau conducteur électriquement formant la première électrode (cathode) de la cellule à hétérojonction en volume de structure inversée.

Cependant, dans certains modes de réalisation, la couche additionnelle 7 peut être formée et donc disposée directement sur la couche mince en matériau conducteur électriquement 2, formant la première électrode et formant, plus particulièrement, la cathode de la cellule cathode de la cellule. C'est, notamment, le cas dans la variante de réalisation représentée sur la figure 3. Dans ce cas, la couche additionnelle 7 comporte, avantageusement, en plus du composé formant des interactions non covalentes avec le matériau carboné semi-conducteur de type n présent dans la couche active 4 (par exemple P4VP ou P4VP+PCBM), un matériau semi-conducteur inorganique de type n, tel que de l'oxyde de zinc ou l'oxyde de titane, ce qui peut alors lui conférer aussi le rôle de couche d'injection d'électrons.

À titre d'exemple, une cellule solaire organique à hétérojonction en volume selon la figure 2 peut, en particulier, être obtenue en déposant à la tournette une solution précurseur contenant le matériau semi-conducteur de type n (par exemple ZnO) et le composé (par exemple P4VP) favorisant les interactions covalentes avec le matériau semi-conducteur de type n présent dans la couche active 4, directement sur une électrode 2 en ITO recouvrant un substrat 1, par exemple en verre. En particulier, pour obtenir une couche additionnelle 7 contenant du ZnO et 5% en poids de P4VP, la solution précurseur peut être obtenue en mélangeant et en agitant pendant 2 jours, 1mL d'une première solution de P4VP à 1g/L préparée dans l'isopropanol et 1mL d'une seconde solution contenant un précurseur de zinc préparée à 20 g/L dans une solution alcoolique de type 2-méthoxyéthanol/éthanolamine. Le dépôt à la tournette de la solution précurseur est, de plus, avantageusement réalisé à l'air, pendant 60s à une vitesse de 1000 tr.min⁻¹, puis pendant 30 s à une vitesse de 2000 tr.min⁻¹, afin d'obtenir une épaisseur d'environ 15 nm. La couche additionnelle 7 est, ensuite, séchée à l'aide d'une plaque chauffante à une température de 150°C, pendant 1 h. Les étapes suivantes permettant de former la couche active 4, la couche d'injection de trous 3 et la seconde électrode 5 peuvent être identiques à celles réalisées pour la cellule selon la figure 2.

Plusieurs séries de cellules photovoltaïques réalisées selon les modes de réalisation décrits ci-dessus et représentés sur les figures 2 et 3 ont été réalisées, afin de mesurer leur performance, tant d'un point de vue rendement de conversion photovoltaïque que d'un point de vue stabilité dans le temps.

Une série (notée ci-après série 1) de deux cellules a été réalisée et testée avec une couche additionnelle constituée de P4VP et dopée par 10% de PCBM (cellules A1 et B1), pour différents rapports en poids pour le mélange P3HT :PCBM contenu dans la couche active électriquement 4. Deux cellules, sans couche additionnelle et avec respectivement des rapports en poids de 1 :1 et de 1 :0,6 entre P3HT :PCBM (cellules C1 et D1) ont aussi été réalisées et testées dans les mêmes conditions que les cellules de la série 1.

Plus particulièrement, le tableau 1 ci-dessous reprend les caractéristiques techniques des cellules mentionnées ci-dessus :

**Tableau 1**

| **Cellule solaire testée** | | **Couche additionnelle** | **Rapport en poids P3HT :PCBM** |
|---|---|---|---|
| **Série 1** | A1 | P4VP+PCBM | 1 :0,6 |
| | B1 | P4VP+PCBM | 1 :1 |
| C1 (témoin) | | Sans | 1 :0,6 |
| D1 (témoin) | | Sans | 1 :1 |

Une fois réalisées, toutes ces cellules ont été disposées dans une boîte à gants sous atmosphère contrôlée, afin d'être testées sous illumination continue.

En particulier, les caractéristiques courant-tension (I(V)) de ces cellules ont été enregistrées sur un dispositif de mesure Courant/Tension commercialisé par Keithley Instruments Sarl sous le modèle SMU 2400, lorsqu'elles sont soumises à un éclairement AM1,5, avec une puissance de 1000 W.m⁻².

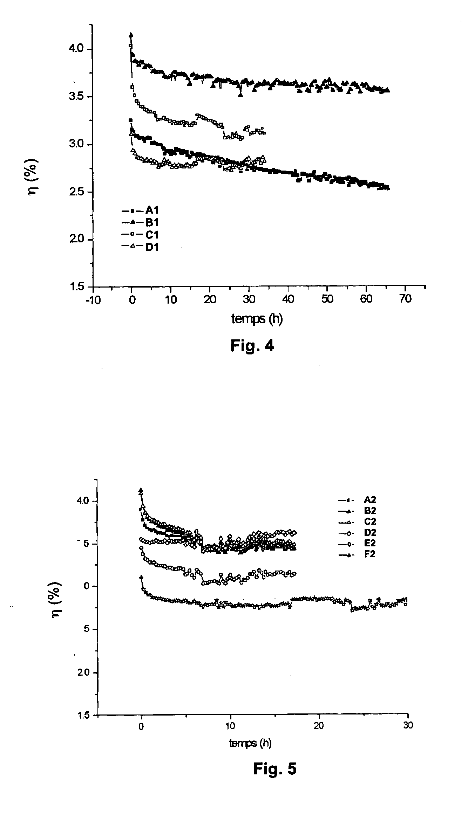

L'évolution du rendement de conversion η en fonction du temps d'exposition à l'éclairement AM1,5 est reportée pour chacune des cellules du tableau 1 sur la figure 4 (cellules A1 à D1).

Les tests réalisés permettent de montrer que les valeurs de rendement obtenues avec la couche additionnelle en P4VP +PCBM (Courbes A1 et B1) sont supérieures aux valeurs de rendement obtenues sans couche additionnelle (Courbes C1 et D1) tout au long du temps d'exposition. Le rendement est même supérieur à celui d'une cellule témoin, pour un rapport en poids de P3HT :PCBM dans la couche active électriquement 4 de 1 :1. Or, ce rapport est particulièrement intéressant pour la tenue de la cellule au vieillissement (bonne stabilité du rendement dans le temps). De plus, ces valeurs de rendement restent stables dans le temps.

Ainsi, la variation du rendement de conversion à t=0 a été étudiée en fonction du pourcentage de PCBM introduit dans la couche additionnelle, pour une couche active contenant un rapport en poids de 1 :1 pour le mélange P3HT :PCBM. Les résultats sont rapportés dans le tableau 2 ci-dessous.

**Tableau 2**

| **% PCBM dans la couche additionnelle** | **Rendement de conversion** |
|---|---|
| 5 | 2.74 % |
| 10 | 3.30 % |
| 15 | 2.84 % |
| 20 | 3.21 % |

Ainsi, une concentration d'environ 10% de PCBM dans la couche additionnelle permet d'obtenir un rendement de conversion optimal, tout en conservant une bonne stabilité dans le temps compte tenu du rapport en poids de 1 :1 pour le mélange P3HT :PCBM utilisé pour la couche active.

Par ailleurs, une série (notée ci-après série 2) de cellules solaires organiques à hétérojonction en volume selon le mode de réalisation représenté sur la figure 3 a été réalisée selon l'étape 1 avec des pourcentages de P4VP variant de 2,5% à 10% en poids de P4VP par rapport au poids du précurseur de ZnO en solution, dans une couche additionnelle constituée de ZnO et de P4VP (cellules A2 à E2), pour une couche active comprenant un mélange P3HT :PCBM avec un rapport en poids de 1 : 1. De plus, à des fins de comparaison, une cellule comprenant seulement une couche en ZnO disposée entre la cathode et la couche active (cellule F2) a été réalisée dans les mêmes conditions que les cellules de la série 3. Ainsi, cette cellule F2 correspond à une cellule selon la figure 3 dans laquelle la couche additionnelle 7 ne comporterait pas de P4VP.

Les cellules A2 à F2 ont été testées sous illumination continue dans les mêmes conditions que la série 1 et l'évolution du rendement de conversion η en % en fonction du temps d'exposition est reportée pour chaque cellule A2 à F2 sur la figure 5. Le rendement de conversion photovoltaïque initial (à t = 0) pour les cellules A2 à E2 est, de plus, reporté dans le tableau 3 ci-dessous ainsi que les caractéristiques techniques de chaque cellule :

**Tableau 3**

| **Cellule solaire testée** | | **Couche additionnelle** | **η (%)** |
|---|---|---|---|
| **Série 2** | A2 | ZnO+2,5% P4VP | 3,4 |
| | B2 | ZnO+5% P4VP | 3,4 |
| | C2 | ZnO+5% P4VP | 3,4 |
| | D2 | ZnO+7,5% P4VP | 3,2 |
| | E2 | ZnO+10,5% P4VP | 3,15 |
| F2 (témoin) | | ZnO | 2,45 |

Ainsi, les résultats reportés dans le tableau 3 ci-dessus permettent de constater que, comme pour les réalisations précédentes, les cellules A2 à E2 présentent des performances accrues par rapport à la cellule témoin. En effet, on constate que le fait d'ajouter le composé P4VP dans la couche en ZnO permet d'obtenir une augmentation du rendement de conversion par rapport à une cellule selon l'art antérieur. De plus, les courbes obtenues sur la figure 6 montrent une stabilité dans le temps des cellules comprenant une couche additionnelles avec ZnO et un pourcentage non nul de P4VP.

Enfin, des essais ont également été réalisés afin d'évaluer le rôle du rapport en poids de P3HT : PCBM (1 :1, 1 :0,8 et 1 :0,6) dans la couche active 4 pour 4 catégories de cellules solaires organiques :
a) une catégorie de cellules témoins comprenant une couche intermédiaire en ZnO et sans couche additionnelle (notée ci-après ZnO seul)
b) une catégorie de cellules comprenant une couche intermédiaire en ZnO et une couche additionnelle en P4VP (notée ci-après ZnO/P4VP)
c) une catégorie de cellules telles que celles réalisées pour la série 1, c'est-à-dire avec une couche intermédiaire en ZnO et une couche additionnelle en P4VP+PCBM (notée ci-après ZnO/P4VP+PCBM) avec, comme pour les cellules A1 et B1, un pourcentage de 10 % de PCBM.
d) une catégorie de cellules telles que celles réalisées pour la série 2, c'est-à-dire sans couche intermédiaire en ZnO mais avec une couche additionnelle contenant ZnO et 5% massique de P4VP (notée ci-après ZnO+P4VP).

Le tableau 4 ci-dessous reprend les rendements de conversion photovoltaïque initiaux (à t =0) obtenus pour ces différentes catégories de cellules solaires organiques.

**Tableau 4**

| **Type de cellule** | **Rendement de conversion photovoltaïque** | | |
|---|---|---|---|
| | P3HT :PCBM 1 :1 | P3HT :PCBM 1 :0.8 | P3HT :PCBM 1 :0.6 |
| ZnO | 2.45 % | 3.49 % | 3.71 % |
| ZnO/P4VP | 3.87 % | 3.79 % | 3.72 % |
| ZnO/P4VP+PCBM | 3.65% | 3.13 % | 3.37 % |
| ZnO+P4VP | 3.40 % | 3.63 % | 3.41 % |

En présence d'une couche additionnelle, tous les rendements obtenus sont supérieurs à 3%, quelque soit le rapport entre P3HT et PCBM dans la couche active. Ceci est d'autant plus intéressant qu'il est bien connu dans l'art antérieur qu'en augmentant la quantité de PCBM, le dispositif est plus stable dans le temps mais il perd ses performances initiales (cas du ZnO dans le tableau 4). Par ailleurs, les tests réalisés montrent la stabilité dans le temps des cellules, notamment celles comprenant une couche additionnelle constituée de P4VP + 10% de PCBM (figure 4).

## Revendications

1. Cellule solaire organique à hétérojonction en volume comportant :
- des première et seconde électrodes (2, 5),
- une couche active électriquement (4), disposée entre les première et seconde électrodes (2, 5) et comprenant un matériau organique semi-conducteur de type p et un matériau carboné semi-conducteur de type n,
- une couche additionnelle (7), disposée entre la première électrode et la couche active électriquement (4), en contact direct avec la couche active électriquement (4),
la couche additionnelle (7) comprend un matériau semi-conducteur de type n et un composé formant des interactions non covalentes avec le matériau carboné semi-conducteur de type n contenu dans la couche active électriquement (4),
le matériau carboné semi-conducteur de type n contenu dans la couche active électriquement (4) est choisi parmi les fullerènes, les nanotubes de carbone, le graphène et les nanographènes, et leurs dérivés solubles,
**caractérisée en ce que** le composé formant des interactions non covalentes avec le matériau carboné semi-conducteur de type n présent dans la couche active électriquement (4) est un polymère choisi parmi des polymères fluorés et des polymères ayant des chaînes latérales comportant au moins un groupement aromatique azoté.

2. Cellule selon la revendication 1, **caractérisée en ce que** la concentration en matériau carboné semi-conducteur de type n varie de manière décroissante dans la couche active électriquement (4), depuis une première face (4a) de la couche active électriquement (4) en contact avec la couche additionnelle (7) jusqu'à une seconde face (4b) de la couche active électriquement (4), opposée à la première face (4a).

3. Cellule selon la revendication 2, **caractérisée en ce que** la concentration en matériau organique semi-conducteur de type p varie de manière croissante dans la couche active électriquement (4), depuis une première face (4a) de la couche active électriquement (4) en contact avec la couche additionnelle (7) jusqu'à une seconde face (4b) de la couche active électriquement (4), opposée à la première face (4a).

4. Cellule selon l'une quelconque des revendications 1 à 3, **caractérisée en ce que** le matériau carboné semi-conducteur de type n contenu dans la couche active électriquement (4) est le PCBM.

5. Cellule selon l'une quelconque des revendications 1 à 4, **caractérisée en ce que** le groupement aromatique azoté est choisi parmi la pyridine, la pyrimidine, la pyrazine, la pyridezine et la triazine.

6. Cellule selon la revendication 5, **caractérisée en ce que** ledit composé est un polymère choisi parmi les polyvinylpyrimidines, les polyvinylpyrazines, les polyvinylpyridazines, la poly(2-vinyl-pyrldine) et la poly(4-vinyl-pyridine).

7. Cellule selon l'une quelconque des revendications 1 à 4, **caractérisée en ce que** ledit composé est un polymère fluoré choisi parmi le polyfluorure de vinylidène, un polytétrafluoroéthylène, un copolymère de tétrafluoréthylène et de perfluorovinyléther.

8. Cellule selon l'une quelconque des revendications 1 à 7, **caractérisée en ce que** le matériau organique semi-conducteur de type p contenu dans la couche active électriquement (4) est choisi parmi les polymères ou copolymères à base de thiophène, de carbazole, de benzothiadiazole, de cyclopentadithiophène et de dikétopyrrolopyrrole.

9. Cellule selon la revendication 8, **caractérisée en ce que** le matériau organique semi-conducteur de type p contenu dans la couche active électriquement (4) est P3HT.

10. Cellule selon l'une quelconque des revendications 1 à 9, **caractérisée en ce que** la couche additionnelle (7) est en contact direct avec la première électrode (2).

11. Cellule selon la revendication 10, **caractérisée en ce que** le composé contenu dans la couche additionnelle (7) est de la poly(4-vinyl-pyridine) et **en ce que** le matériau semi-conducteur de type n contenu dans la couche additionnelle (7) est choisi parmi l'oxyde de zinc et l'oxyde de titane.

12. Cellule selon l'une quelconque des revendications 1 à 9, **caractérisée en ce qu'**une couche mince intermédiaire, en matériau semi-conducteur de type n, est disposée entre la couche additionnelle (7) et la première électrode (2).

13. Cellule selon la revendication 12, **caractérisée en ce que** le composé contenu dans la couche additionnelle (7) est de la poly(4-vinyl-pyridine) et **en ce que** le matériau semi-conducteur de type n contenu dans la couche additionnelle (7) est le PCBM.

## Patentansprüche

1. Bulk-Heteroübergangs-Sollarzelle, umfassend:
- eine erste und eine zweite Elektrode (2, 5),
- eine elektrisch aktive Schicht (4), die zwischen der ersten und der zweiten Elektrode (2, 5) angeordnet ist und die ein organisches Halbleitermaterial vom p-Typ sowie ein kohlenstoffhaltiges Halbleitermaterial vom n-Typ umfasst,
- eine zusätzliche Schicht (7), die zwischen der ersten Elektrode und der elektrisch aktiven Schicht (4), in direktem Kontakt mit der elektrisch aktiven Schicht (4) angeordnet ist,
wobei die zusätzliche Schicht (7) ein Halbleitermaterial vom n-Typ sowie eine Verbindung umfasst, die nicht-kovalente Wechselwirkungen mit dem in der elektrisch aktiven Schicht (4) enthaltenen kohlenstoffhaltigen Halbleitermaterial vom n-Typ bildet,
wobei das kohlenstoffhaltige Halbleitermaterial vom n-Typ, welches in der elektrisch aktiven Schicht (4) enthalten ist, aus den Fullerenen, den Kohlenstoffnanoröhren, Graphen und den Nanographenen sowie ihren löslichen Derivaten ausgewählt ist,
**dadurch gekennzeichnet, dass** die Verbindung, die nicht-kovalente Wechselwirkungen mit dem in der elektrisch aktiven Schicht (4) vorhandenen kohlenstoffhaltigen Halbleitermaterial vom n-Typ bildet, ein Polymer ist, welches aus Fluorpolymeren und Polymeren, die Seitenketten mit wenigstens einer aromatischen Stickstoffgruppe aufweisen, ausgewählt ist.

2. Zelle nach Anspruch 1, **dadurch gekennzeichnet, dass** die Konzentration an kohlenstoffhaltigem Halbleitermaterial vom n-Typ sich in der elektrisch aktiven Schicht (4), von einer ersten Seite (4a) der elektrisch aktiven Schicht (4), welche mit der zusätzlichen Schicht (7) in Kontakt ist, bis zu einer zweiten Seite (4b) der elektrisch aktiven Schicht (4), welche der ersten Seite (4a) gegenüberliegt, in abnehmender Weise ändert.

3. Zelle nach Anspruch 2, **dadurch gekennzeichnet, dass** die Konzentration an organischem Halbleitermaterial vom p-Typ sich in der elektrisch aktiven Schicht (4), von einer ersten Seite (4a) der elektrisch aktiven Schicht (4), welche mit der zusätzlichen Schicht (7) in Kontakt ist, bis zu einer zweiten Seite (4b) der elektrisch aktiven Schicht (4), welche der ersten Seite (4a) gegenüberliegt, in zunehmender Weise ändert.

4. Zelle nach einem der Ansprüche 1 bis 3, **dadurch gekennzeichnet, dass** das kohlenstoffhaltige Halbleitermaterial vom n-Typ, welches in der elektrisch aktiven Schicht (4) enthalten ist, PCBM ist.

5. Zelle nach einem der Ansprüche 1 bis 4, **dadurch gekennzeichnet, dass** die aromatische Stickstoffgruppe aus Pyridin, Pyrimidin, Pyrazin, Pyridazin und Triazin ausgewählt ist.

6. Zelle nach Anspruch 5, **dadurch gekennzeichnet, dass** die Verbindung ein Polymer ist, das aus den Polyvinylpyrimidinen, den Polyvinylpyrazinen, den Polyvinylpyridazinen, Poly(2-vinyl-pyridin) und Poly(4-vinyl-pyridin) ausgewählt ist.

7. Zelle nach einem der Ansprüche 1 bis 4, **dadurch gekennzeichnet, dass** die Verbindung ein Fluorpolymer ist, das aus Polyvinylidenfluorid, einem Polytetrafluorethylen, einem Tetrafluorethylen- und Perfluorvinylether-Copolymer ausgewählt ist.

8. Zelle nach einem der Ansprüche 1 bis 7, **dadurch gekennzeichnet, dass** das organische Halbleitermaterial vom p-Typ, welches in der elektrisch aktiven Schicht (4) enthalten ist, aus den Polymeren oder Copolymeren auf der Basis von Thiophen, von Carbazol, von Benzthiadiazol, von Cyclopentadithiophen und von Diketopyrrolopyrrol ausgewählt ist.

9. Zelle nach Anspruch 8, **dadurch gekennzeichnet, dass** das organische Halbleitermaterial vom p-Typ, welches in der elektrisch aktiven Schicht (4) enthalten ist, P3HT ist.

10. Zelle nach einem der Ansprüche 1 bis 9, **dadurch gekennzeichnet, dass** die zusätzliche Schicht (7) in direktem Kontakt mit der ersten Elektrode (2) ist.

11. Zelle nach Anspruch 10, **dadurch gekennzeichnet, dass** die in der zusätzlichen Schicht (7) enthaltene Verbindung Poly(4-vinyl-pyridin) ist und dass das Halbleitermaterial vom n-Typ, welches in der zusätzlichen Schicht (7) enthalten ist, aus Zinkoxid und Titanoxid ausgewählt ist.

12. Zelle nach einem der Ansprüche 1 bis 9, **dadurch gekennzeichnet, dass** eine dünne Zwischenschicht aus Halbleitermaterial vom n-Typ zwischen der zusätzlichen Schicht (7) und der ersten Elektrode (2) angeordnet ist.

13. Zelle nach Anspruch 12, **dadurch gekennzeichnet, dass** die in der zusätzlichen Schicht (7) enthaltene Verbindung Poly(4-vinyl-pyridin) ist und dass das Halbleitermaterial vom n-Typ, welches in der zusätzlichen Schicht (7) enthalten ist, PCBM ist.

## Claims

1. Bulk heterojunction organic solar cell comprising:
- first and second electrodes (2, 5),
- an electrically active layer (4), disposed between the first and second electrodes (2, 5) and comprising a p-type semiconductor organic material and a n-type semiconductor carbonaceous material,
- an additional layer (7), disposed between the first electrode and the electrically active layer (4), in direct contact with the electrically active layer (4),
the additional layer (7) comprises a n-type semiconductor material and a compound forming noncovalent interactions with the n-type semiconductor carbonaceous material contained in the electrically active layer (4),
the n-type semiconductor carbonaceous material contained in the electrically active layer (4) is selected among fullerenes, carbon nanotubes, graphene and nanographenes, and soluble derivatives thereof,
**characterized in that** the compound forming noncovalent interactions with n-type semiconductor carbonaceous material present in the electrically active layer (4) is a polymer chosen among fluorinated polymers and polymers having side chains comprising at least one nitrogenized aromatic group.

2. Cell according to claim 1, **characterized in that** the concentration of the n-type semiconductor carbonaceous material decreasingly varies in the electrically active layer (4), from a first face (4a) of the electrically active layer (4) in contact with the additional layer (7) to a second face (4b) of the electrically active layer (4), opposite to the first face (4a).

3. Cell according to claim 2, **characterized in that** the concentration of the p-type semiconductor organic material increasingly varies in the electrically active layer (4), from a first face (4a) of the electrically active layer (4) in contact with the additional layer (7) to a second face (4b) of the electrically active layer (4), opposite to the first face (4a).

4. Cell according to anyone of the claims 1 to 3, **characterized in that** the n-type semiconductor carbonaceous material contained in the electrically active layer (4) is PCBM.

5. Cell according to anyone of the claims 1 to 4, **characterized in that** the nitrogenized aromatic group is selected among pyridine, pyrimidine, pyrazine, pyridazine and triazine.

6. Cell according to claim 5, **characterized in that** said compound is a polymer chosen among polyvinylpyrimidines, polyvinylpyrazines, polyvinylpyridazines, poly(2-vinyl-pyridine) and poly(4-vinyl-pyridine).

7. Cell according to anyone of the claims 1 to 4, **characterized in that** said compound is a fluorinated polymer selected among vinylidene polyfluoride, polytetrafluoroethylene, copolymer of tetrafluorethylene and perfluorovinylether.

8. Cell according to anyone of the claims 1 to 7, **characterized in that** the p-type semiconductor organic material contained in the electrically active layer (4) is selected among polymers or copolymers containing thiophene, carbazole, benzothiadiazole, cyclopentadithiophene and diketopyrrolopyrrole.

9. Cell according to claim 8, **characterized in that** the p-type semiconductor organic material contained in the electrically active layer (4) is P3HT.

10. Cell according to anyone of the claims 1 to 9, **characterized in that** the additional layer (7) is in direct contact with the first electrode (2).

11. Cell according to claim 10, **characterized in that** the compound contained in the additional layer (7) is poly(4-vinyl-pyridine) and **in that** the n-type semiconductor material contained in the additional layer (7) is selected among zinc oxide and titanium oxide.

12. Cell according to anyone of the claims 1 to 9, **characterized in that** an intermediate thin layer, made of a n-type semiconductor material, is disposed between the additional layer (7) and the first electrode (2).

13. Cell according to claim 12, **characterized in that** the compound contained in the additional layer (7) is poly(4-vinyl-pyridine) and **in that** the n-type semiconductor material contained in the additional layer (7) is PCBM.
